# EUROPÄISCHE PATENTSCHRIFT

(11) **EP 1 584 103 B1**
(45) Veröffentlichungstag und Bekanntmachung des Hinweises auf die Patenterteilung: **01.02.2017**
(21) Anmeldenummer: 03815077.7
(22) Anmeldetag: 31.12.2003
(51) Int. Cl.: H01L 21/02, H01L 21/308, H01L 21/768, H01L 23/522, H01L 23/532, H01L 23/00

(54) **ZWEISTUFIGES ÄTZVERFAHREN ZUM HERSTELLEN EINER INTEGRIERTEN SCHALTUNGSANORDNUNG, INSBESONDERE MIT KONDENSATORANORDNUNG**
TWO-STAGE ETCHING PROCESS FOR PRODUCING AN INTEGRATED CIRCUIT ARRANGEMENT, IN PARTICULAR COMPRISING A CAPACITOR ASSEMBLY
PROCEDE EN DEUX ETAPES POUR PRODUIRE UN CIRCUIT INTEGRE, NOTAMMENT UN ENSEMBLE CONDENSATEUR

(30) Priorität: 15.01.2003 DE 10301243
(43) Veröffentlichungstag der Anmeldung: 12.10.2005
(73) Patentinhaber: Infineon Technologies AG, 85579 Neubiberg (DE)
(72) Erfinder: BARTH, Hans-Joachim, 81245 München (DE); HOLZ, Jürgen, 01127 Dresden (DE)
(74) Vertreter: Kindermann, Peter
(86) Internationale Anmeldenummer: PCT/EP2003/014974
(87) Internationale Veröffentlichungsnummer: WO 2004/064160

(56) Entgegenhaltungen:
- EP-A- 1 001 459
- US-A- 5 914 279
- US-A- 6 027 980
- US-A- 6 037 255
- US-A- 6 107 136
- US-A- 6 143 649
- US-A1- 2002 173 163
- US-A1- 2002 179 955
- US-A1- 2003 008 490

## Beschreibung

Die Erfindung betrifft ein Verfahren zum Herstellen einer integrierten Schaltungsanordnung mit den Schritten:
- Aufbringen einer dielektrischen Schicht auf einer Elektrodenschicht, die mindestens eine Elektrode enthält,
- Aufbringen einer Resistschicht,
- Strukturieren der dielektrischen Schicht, und
- Entfernen von Resten der Resistschicht.

Die dielektrische Schicht hat bei einer Temperatur von 20°C einen spezifischen elektrischen Widerstand bspw. größer als 10¹⁰ Ωcm oder sogar 10¹⁶ Ωcm. Beispielsweise wird Siliziumdioxid als Material für die dielektrische Schicht eingesetzt. Jedoch werden auch Materialien mit einer Dielektrizitätskonstante größer als 3,9 eingesetzt, beispielsweise Siliziumnitrid, Aluminiumoxid oder Tantalpentoxid.

Die Elektrodenschicht enthält dagegen ein gut leitfähiges Material, das einen spezifischen elektrischen Widerstand kleiner als bspw. 10⁻⁴ Ωcm hat. Meist liegt der spezifische elektrische Widerstand jedoch noch um eine oder mehrere Zehnerpotenzen unter diesem Wert. Beispiele für Materialien in der Elektrodenschicht sind Aluminium, Aluminiumlegierungen, Kupfer, Kupferlegierungen, Silber, Titan oder andere Metalle bzw. Verbindungen wie Tantalnitrid TaN oder Titannitrid TiN.

Beispielsweise könnte man die Resistschicht entfernen, nachdem die dielektrische Schicht vollständig mit Hilfe der Resistschicht strukturiert worden ist. Dies hat jedoch den Nachteil, dass während des Entfernens des Resists Teile der Elektrodenschicht freiliegen und damit durch die zum Entfernen des Resists dienenden chemischen Verfahren angegriffen werden. Das Entfernen des Fotolacks wird beispielsweise durch Veraschen bei einer Temperatur von ca. 200°C und einem folgenden Ablösen der Asche mit einem Lösungsmittel durchgeführt. Aber auch ein Entfernen des Fotolacks nur mit einem nasschemischen Verfahren ist möglich.

Beispielsweise kann das Material der Elektrodenschicht oxidiert werden. Die so entstandenen Oxidationsprodukte müssen mit einem speziellen Reinigungsschritt wieder entfernt werden. Dieser Reinigungsschritt muss speziell entwickelt und optimiert werden, insbesondere, wenn bestimmte Oxide entfernt werden müssen, beispielsweise Kupferoxide. Werden die beim Entfernen des Resists auf der Elektrodenschicht entstandenen Reaktionsprodukte nicht vollständig entfernt, so führt dies zu hohen Übergangswiderständen. Eine Verschlechterung der Zuverlässigkeit der elektrisch leitenden Verbindungen ist die Folge.

Außerdem können die beim Entfernen des Resists entstehenden chemischen Verbindungen im Bereich der freiliegenden Bereiche der Elektrodenschicht auch unter die dielektrische Schicht gelangen. Beim Entfernen der Reaktionsprodukte kommt es dann zu Unterätzungen, welche die elektrischen Eigenschaften der integrierten Schaltungsanordnung erheblich verschlechtern. Auch aus diesem Grund muss ein erheblicher Aufwand in die Entwicklung des Reinigungsschrittes investiert werden.

Die US 6,107,136 zeigt bei der Herstellung eines Kondensators mit einem Dielektrikum hoher Dielektrizitätskonstante die Verwendung eines Teils der elektrisch leitfähigen Bodenelektrode des Kondensators als Hartmaske bei der Strukturierung eines elektrisch isolierenden Bereiches, der später von der Bodenelektrode umschlossen wird. Der elektrisch isolierende Bereich wird aus einer Schicht erzeugt, die eine Schichtdicke im bereich von etwa 250 bis 400 Nanometer hat.

Aus der US 6,027,980 ist die Verwendung einer Hartmaske bei der Strukturierung eines einen Schichtstapels durchdringenden Kontaktlochs oder Vias bekannt. In dem Schichtstapel wechseln sich elektrisch isolierenden Schichten und elektrisch leitfähige Schichten ab. Eine zur Strukturierung der Hartmaske dienende Resistschicht wird erst entfernt, nachdem die oberste isolierende Schicht des zu strukturierenden Stapel bereits vollständig strukturiert worden ist.

Aus der US 6,037,255 ist ein Verfahren bekannt, bei dem im Rahmen eines Dual-Damascene Prozesses ein Zwischenlagendielektrikum aus einem Polymer mit einer elektrisch isolierenden Hartmaske strukturiert wird. Das Zwischenlagendielektrikum hat eine Dicke im Bereich von 200 nm bis 2 Mikrometer. Ein zur Strukturierung der Hartmaske verwendetes Resist wird während der Strukturierung des Polymers mit dem zum Strukturieren des Polymers verwendeten Ätzprozess entfernt.

Die US 5,914,279 zeigt die Verwendung von Hartmasken aus polykristallinem Silizium zur Ätzung von Schichtstapeln, deren Dicke größer als 150 Nanometern ist.

Aus der EP 1 001 459 A2 sind eine Vielzahl von Verfahren zum Herstellen eines Kondensators mit einem Dielektrikum hoher Dielektrizitätskonstante bekannt, wobei Hartmasken verwendet werden.

Die US 2002/0173163 betrifft ein Verfahren zum Strukturieren einer Hartmaske mit einer Hartmaske. Die zuletzt verbleibende Hartmaske dient dann zum Strukturieren einer Öffnung mit extrem hohen Aspektverhältnis, wobei auf DRAM-Deep-Trenches Bezug genommen wird, oder eines schwer zu strukturierenden Materials, wobei auf Platin oder Iridium Bezug genommen wird.

Ein weiteres Verfahren ist aus der US 2003/0008490 A1 bekannt, wobei jedoch für low k Materialien keine Schichtdicken genannt sind. Aus der US 6,143,649 ist ein Verfahren bekannt, bei dem eine Hartmaske schräge Seitenwände für ein Via bildet und in der Schaltungsanordnung verbleibt.

Die US 2002/0179955 A1 zeigt eine Halbleiteranordnung mit MIM-Kondensator.

Es ist Aufgabe der Erfindung, zum Herstellen einer integrierten Schaltungsanordnung, insbesondere mit einer Kondensatoranordnung, ein einfaches Verfahren anzugeben, das insbesondere ohne zusätzlichen Reinigungsschritt bzw. mit einem sehr einfachen Reinigungsschritt durchgeführt werden kann.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass das Entfernen des Resists bei freiliegenden Bereichen der Elektrodenschicht vermieden werden muss.

Deshalb wird beim erfindungsgemäßen Verfahren mindestens eine Hartmaskenschicht auf die dielektrische Schicht aufgebracht. Die Hartmaskenschicht besteht beispielsweise aus einem Oxid oder aus einem anderen Material, das sich bei der Strukturierung von Kontaktlöchern bzw. sogenannten Vias selektiv zu der unmittelbar darunter liegenden dielektrischen Schicht ätzen lässt. Die Ätzung ist dabei vorzugsweise eine Trockenätzung. Jedoch werden auch Nassätzungen zum Erzeugen der Kontaktlöcher bzw. Vias eingesetzt. Das Kontaktloch bzw. das Via wird jedoch durch diese Ätzung nicht vollständig geöffnet, d.h. die dielektrische Schicht wird nicht durchätzt. Anschließend wird das Resist entfernt, beispielsweise durch sogenanntes Resiststrippen. Dabei sind die Elektroden in der Elektrodenschicht noch durch die dielektrische Schicht geschützt.

Erst danach erfolgt eine weitere Ätzung zum vollständigen Strukturieren der dielektrischen Schicht mit Hilfe der Hartmaskenschicht. Bei dieser Ätzung wird die dielektrische Schicht im Bereich der Kontaktlöcher bzw. Vias entfernt und damit das Kontaktloch bzw. Via geöffnet, wobei ein darunter liegender Bereich mindestens einer Elektrode der Elektrodenschicht freigelegt wird. Die Hartmaskenschicht ersetzt bei dieser Ätzung die Funktion des nicht mehr vorhandenen Resists. Die zweite Ätzung ist beispielsweise eine Trockenätzung oder eine Nassätzung.

Bei dem erfindungsgemäßen Verfahren ist die an die dielektrische Schicht angrenzende Schicht der Hartmaskenschicht eine elektrisch isolierende Schicht, die nach dem Herstellen der Kontaktlöcher bzw. Vias wieder entfernt wird. Die dazu benötigte Ätzung ist selektiv zu der darunter liegenden dielektrischen Schicht und greift auch die freigelegten Bereiche der Elektrodenschicht insbesondere bei einer Nassätzung nicht wesentlich an. Um eine Beschädigung der dielektrischen Schicht durch Plasmaeinwirkungen zu vermeiden, wird bei der ersten Alternative vorzugsweise eine nass-chemische Ätzung durchgeführt, jedoch lässt sich auch eine Trockenätzung zum vollständigen Entfernen der Hartmaskenschicht einsetzen.

Bei einer nicht erfindungsgemäßen anderen Alternative des Verfahrens ist die an die dielektrische Schicht angrenzende Schicht der Hartmaskenschicht eine elektrisch leitfähige Schicht. Die elektrisch leitfähige Schicht verbleibt bereichsweise auf der dielektrischen Schicht und bildet somit einen Teil einer Elektrode, die unmittelbar an die dielektrische Schicht angrenzt. Da die elektrisch leitfähige Schicht in dem Elektrodenbereich nicht entfernt werden muss, wird auch die dielektrische Schicht in diesem Bereich nicht durch einen Ätzvorgang angegriffen bzw. geschädigt.

Damit bieten die beiden Alternativen zwei einfache Möglichkeiten für die Herstellung der integrierten Schaltungsanordnung. Insbesondere ist weniger Entwicklungsaufwand erforderlich, da kein komplizierter Reinigungsschritt ausgeführt werden muss, mit dem von Bereichen der Elektrodenschicht Reaktionsprodukte entfernt werden müssen, die beim Entfernen des Resists mit freiliegenden Elektroden der Elektrodenschicht entstehen würden. Die Verfahrensführung ist einfach, weil die Kontaktlochätzung bzw. die Viaätzung nur in zwei Stufen ausgeführt wird, wobei zwischen den beiden Stufen das Resist entfernt wird. Als Hartmaske wird eine leicht abzuscheidende Schicht verwendet, die dann zur Strukturierung der Kontaktlöcher bzw. der Vias dient. Die Hartmaskenschicht ist gegebenenfalls auch selektiv und schonend zur darunter liegenden dielektrischen Schicht entfernbar. Beispielsweise lässt sich als Hartmaskenschicht eine CVD-Oxidschicht einsetzen, wie sie als Intermetalldielektrikum in Metallisierungslagen verwendet wird.

Bei einer Weiterbildung des erfindungsgemäßen Verfahrens wird die elektrisch isolierende Schicht der Hartmaskenschicht nass-chemisch entfernt. Nass-chemische Ätzungen greifen die unter der Hartmaskenschicht liegende dielektrische Schicht weniger stark an als Trockenätzungen, die beispielsweise mit Hilfe eines Plasmas als chemisch physikalisches Trockenätzen durchgeführt werden.

Bei einer Ausgestaltung wird die elektrisch isolierende Schicht unter Ausschluss von Sauerstoff geätzt, insbesondere unter Verwendung einer Inertgasatmosphäre, beispielsweise einer Stickstoffgasatmosphäre. Durch diese Maßnahme wird eine Oxidation der freiliegenden Bereiche der Elektrodenschicht beim Entfernen der Hartmaskenschicht vermieden. Durch diese Maßnahmen bilden sich keine Reaktionsprodukte, insbesondere keine Oxidationsprodukte, auf den freiliegenden Bereichen bzw. zwischen Elektrodenbereichen und der dielektrischen Schicht im Umfeld der freiliegenden Bereiche. Ein Entfernen dieser Reaktionsprodukte und die damit verbundene Unterätzung sind nicht erforderlich.

Wird bei einer nächsten Ausgestaltung die elektrisch isolierende Schicht vollständig entfernt, so ist kein weiteres Lithografieverfahren erforderlich, da ganzflächig geätzt werden kann.

Bei der nicht erfindungsgemäßen zweiten Alternative wird ein verbleibender Teil der elektrisch leitfähigen Schicht als Teil der Deckelektrode eines Kondensators oder eines anderen Bauelementes ausgebildet, z.B. einer Bond-Anschlusselektrode. Insbesondere bei Kondensatoren bestehen sehr hohe Anforderungen an die Qualität der dielektrischen Schicht. Insbesondere darf die dielektrische Schicht nicht durch Ätzvorgänge angeätzt werden. Dies wird durch die verbleibenden Bereiche der elektrisch leitfähigen Schicht gewährleistet.

Bei einer nächsten nicht erfindungsgemäßen Weiterbildung des erfindungsgemäßen Verfahrens enthält die Hartmaskenschicht wie bei der zweiten Alternative eine an die dielektrische Schicht angrenzende elektrisch leitfähige Schicht und eine darüber liegende elektrisch isolierende Schicht. Nach der Strukturierung der dielelektrischen Schicht wird die elektrisch isolierende Schicht entfernt. Die elektrisch leitfähige Schicht verbleibt bereichsweise und in ursprünglicher oder verringerter Schichtdicke in der integrierten Schaltungsanordnung. Diese Weiterbildung ermöglicht ein größeres Prozessfenster im Vergleich zu einem Verfahren, bei dem die Hartmaskenschicht nur eine elektrisch leitfähige Schicht enthält. Außerdem lässt sich durch diese Weiterbildung die Dicke der elektrisch leitfähigen Schicht in einem größeren Bereich auswählen. Insbesondere lässt sich die elektrisch leitfähige Schicht dünner ausführen, als es bei einem Verfahren der Fall ist, bei dem die Hartmaskenschicht nur eine elektrisch leitfähige Schicht enthält.

Bei einer nächsten nicht erfindungsgemäßen Weiterbildung mit einer Hartmaskenschicht, die eine elektrisch leitfähige Schicht und eine elektrisch isolierende Schicht enthält, wird die elektrisch isolierende Schicht nass-chemisch, trockenchemisch oder chemisch-physikalisch entfernt. Eine Schädigung der dielektrischen Schicht bei diesem Verfahren ist nicht zu befürchten, weil die elektrisch leitfähige Schicht die dielektrische Schicht schützt. Bei einer Ausgestaltung dient die elektrisch leitfähige Schicht als Ätzstoppschicht beim Entfernen der elektrisch isolierenden Schicht. Es lässt sich ein Ätzverfahren mit Endpunkterfassung oder auch ein zeitgesteuertes Ätzverfahren durchführen. 7

Bei einer nächsten Weiterbildung des erfindungsgemäßen Verfahrens wird vor dem Aufbringen der dielektrischen Schicht mindestens ein Graben erzeugt. Die dielektrische Schicht wird auch am Boden des Grabens aufgebracht. Diese Maßnahme wird insbesondere bei der Verwendung eines Kupfermaterials in einer über der Elektrodenschicht zu erzeugenden oberen Elektrodenschicht verwendet. Bei der Herstellung von Kupfermetallisierungen wird nämlich auf ein sogenanntes Damascene-Verfahren bzw. auf eine Duales-Damascene-Verfahren zurückgegriffen. Beim Ätzen der Gräben wird die dielektrische Schicht nicht geschädigt, weil sie erst nach dem Ausbilden des Grabens erzeugt wird.

Beim einer nächsten Weiterbildung besteht die Hartmaskenschicht aus einer Oxidschicht, insbesondere aus einer Siliziumdioxidschicht. Jedoch werden auch Hartmaskenschichten aus Titan oder Titannitrid oder aus einem anderen geeigneten Material eingesetzt.

Bei einer anderen Weiterbildung besteht die dielektrische Schicht aus Siliziumnitrid, aus Siliziumkarbid, aus Aluminiumoxid oder aus einem anderen Material mit einer großen Dielektrizitätskonstante. Große Dielektrizitätskonstanten sind Dielektrizitätskonstanten größer als 3,9. Beispiele für solche Materialien sind Aluminiumnitrid, Hafniumdioxid, Tantalpentoxid, Zirkoniumdioxid, Bariumstrontiumtitanat und Bleizirkoniumtitanat. Jedoch gibt es auch andere geeignete Materialien mit großen Dielektrizitätskonstanten.

Bei einer nächsten Weiterbildung besteht die Elektrodenschicht aus einem Material, das beim Entfernen der Resistschicht ohne zusätzliche Maßnahmen angegriffen werden würde, insbesondere aus Kupfer, aus einer Kupferlegierung, aus Silber oder aus einer Silberlegierung. Das angreifbare Material der Elektrodenschicht liegt bei einer Ausgestaltung unmittelbar an der dielektrischen Schicht an.

Bei einer anderen Weiterbildung wird nach dem Strukturieren der dielektrischen Schicht eine weitere Elektrodenschicht erzeugt, die mindestens eine Elektrode enthält. Bei einer Ausgestaltung besteht die Elektrode aus Aluminium, aus einer Aluminiumlegierung, aus Kupfer oder aus einer Kupferlegierung. Jedoch werden auch Elektroden aus anderen Materialien hergestellt. Die Legierungen enthalten bei einer Ausgestaltung Zusätze kleiner als 5 Masseprozent.

Bei dem erfindungsgemäßen Verfahren sind beide Elektrodenschichten, an die die dielektrische Schicht angrenzt, als Metallisierungslagen mit einer Vielzahl von Leitbahnen ausgebildet. Zwischen solchen Metallisierungslagen lassen sich Kondensatoren mit einer hohen Flächenkapazität herstellen, wenn der Abstand zwischen den benachbarten Flächen von Elektroden verschiedener Metallisierungslagen kleiner als 150 nm oder sogar kleiner als 100 nm ist.

Bei einer anderen Weiterbildung des erfindungsgemäßen Verfahrens werden die strukturierten Reste der Resistschicht mit einem Verfahren entfernt, dass sich vom Verfahren zur Strukturierung der dielektrischen Schicht unterscheidet. Demzufolge werden die Reste der Resistschicht nicht allein durch den beim Ätzen der Hartmaske unvermeidlichen Lackabtrag entfernt.

Bei einer Weiterbildung ist ein Dickenunterschied von Linerschichten auf der verbleibenden Hartmaske und in Durchbrüchen der verbleibenden Hartmaske größer als 30 nm. Der Dickenunterschied ist damit größer als ein Dickenunterschied allein aus dem nicht konformen Abscheiden einer Schicht in dem Durchbruch.

Im Folgenden werden Ausführungsbeispiele der Erfindung an Hand der beiliegenden Zeichnungen erläutert. Darin zeigen:
- Figuren 1A bis 1F: Verfahrensstufen bei der Herstellung einer integrierten Schaltungsanordnung mit Kondensator, und
- Figur 2: eine gemäß einem anderen Verfahren gefertigte Schaltungsanordnung mit Kondensator.

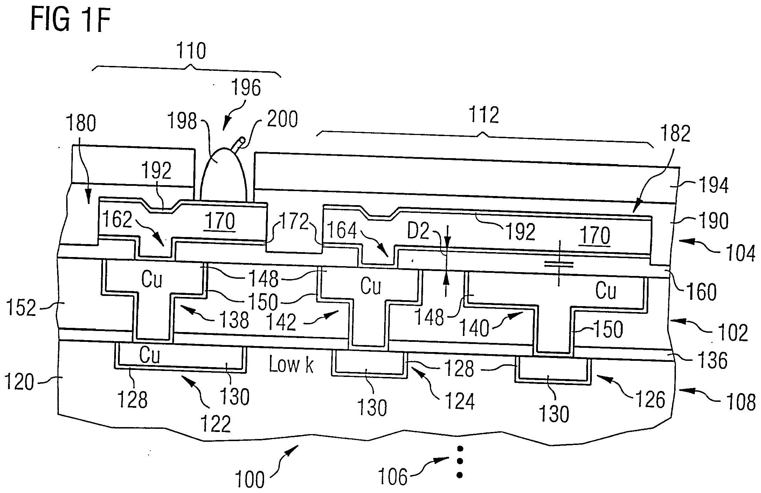

Figur 1F zeigt eine Schaltungsanordnung 100 mit einer vorletzten Metallisierungslage 102 und einer letzten Metallisierungslage 104. Unter der vorletzten Metallisierungslage 102 liegt eine Metallisierungslage 108. Unter der Metallisierungslage 108 angeordnete Metallisierungslagen 106 und ein Substrat der Schaltungsanordnung 100 sind durch Punkte angedeutet.

Als Beispiele für Bauelemente, die in den beiden obersten Metallisierungslagen 102 und 104 angeordnet werden können, sind in Figur 1F eine Bondverbindung 110 und ein linearer Kondensator 112 dargestellt.

Die Metallisierungslage 108 enthält als Isoliermaterial ein Material mit einer kleinen Dielektrizitätskonstante k (BLOK - Barrier LOw K), beispielsweise SILK (Silicon LOw K), d.h. z.B. poröses Siliziumdioxid 120. Alternativ wird FSG (Fluoride Silicate Glass) als Isoliermaterial in der Metallisierungslage 108 verwendet. Im Bereich der Bondverbindung 110 enthält die Metallisierungslage 108 eine Leitbahn 122. Die Leitbahn 122 enthält eine Liner-/Barriereschicht 128 und Kupfer 130. Die Barriereschicht 128 besteht beispielsweise aus Titannitrid. Unterhalb des Kondensators 112 enthält die Metallisierungslage 108 Leitbahnen 124 und 126, welche zu Bauelementen führen, die mit dem Kondensator 112 verbunden sind.

Zwischen der Metallisierungslage 108 und der Metallisierungslage 102 liegt eine Barriereschicht 136 aus z.B. Siliziumnitrid mit einer Dicke kleiner 20 nm, beispielsweise mit einer Dicke von 15 nm. Alternativ wird auch in BLOK-Material (Barrier LOw K) eingesetzt, z.B. Siliziumcarbid.

Die Metallisierungslage 102 enthält im Bereich der Bondverbindung 110 eine Leitung 138, die von der Leitbahn 122 zu der Bondverbindung 110 führt. Im rechten Bereich des Kondensators 112 enthält die Metallisierungslage 102 eine untere Elektrode 140 des Kondensators 112. Die untere Elektrode 140 ist mit der Leitbahn 126 verbunden. Im linken Bereich des Kondensators 112 enthält die Metallisierungslage 102 einen Verbindungsabschnitt 142, der mit der Leitbahn 124 verbunden ist.

Die Leitung 138, die untere Elektrode 140 und der Verbindungsabschnitt 142 werden durch Kupfer 148 gebildet, das durch eine Liner-/Barriereschicht 150 von dem Siliziumdioxid 152 getrennt ist, welches in der Metallisierungslage 102 zur Isolation der einzelnen Verbindungen enthalten ist. Die Liner-/Barriereschicht 150 besteht z.B. aus Titannitrid.

Zwischen der Metallisierungslage 102 und der Metallisierungslage 104 befindet sich eine Zwischenlage 160, deren Dicke D2 etwa 100 nm beträgt. Die Zwischenlage 160 besteht beispielsweise vollständig aus Siliziumnitrid.

Im Bereich der Bondverbindung 110 ist die Zwischenlage 160 von einem Via bzw. Kontaktloch 162 durchdrungen, das meist als Via bezeichnet wird, weil es zwischen zwei Metallisierungslagen liegt. Im Bereich des Kondensators 112 wird die Zwischenlage 160 von einem Via bzw. Kontaktloch 164 durchdrungen, das zum Verbindungsabschnitt 142 führt. Die Kontaktlöcher bzw. Vias 162 und 164 sind mit Aluminium 170 gefüllt. Eine Ling-/Barriereschicht 172, beispielsweise aus Titannitrid, trennt das Aluminium 170 von der Zwischenlage 160 sowie dem Kupfer in der Metallisierungslage 102. Liner-/Barriereschicht 172 verbessert die Haftung und verhindert Diffusionsvorgänge. Die Liner-/Barriereschicht 172 verhindert bzw. reduziert auch die Elektromigration von Aluminium. Die Zwischenlage 160 ist bis auf die Durchbrüche für die Kontaktlöcher 162 und 164 und für weitere, nicht dargestellte Kontaktlöcher, ganzflächig im Bereich zwischen den Metallisierungslagen 102 und 104 ausgebildet.

Die Metallisierungslage 104 enthält im Bereich der Bondverbindung 110 eine Anschlussplatte 180 aus Aluminium 170. Im Bereich des Kondensators 112 enthält die Metallisierungslage 104 eine obere Elektrode 182 des Kondensators 112 aus Aluminium 170. Die obere Elektrode 182 ist über das Kontaktloch 164 angeschlossen und überdeckt die gesamte untere Elektrode 140.

Zur Isolation zwischen der Anschlussplatte 180 und der oberen Elektrode 182 enthält die Metallisierungslage 104 Siliziumdioxid 190. Auf den oberen Flächen der Anschlussplatte 180 und der oberen Elektrode 182 befinden sich strukturierte Restbereiche einer Liner-/Antireflexionsschicht 192, die u.a. eine Elektromigration verhindert. Die Metallisierungslage 104 ist durch eine Passivierungsschicht 194 bedeckt, die beispielsweise aus Siliziumnitrid besteht.

Im Bereich der Bondverbindung 110 befindet sich eine Aussparung 196 in der Passivierungsschicht 194 und in dem Siliziumdioxid 190. Die Aussparung 196 endet auf der Anschlussplatte 180. In der Aussparung 196 befindet sich der Anschlusskopf 198 eines Bonddrahtes 200.

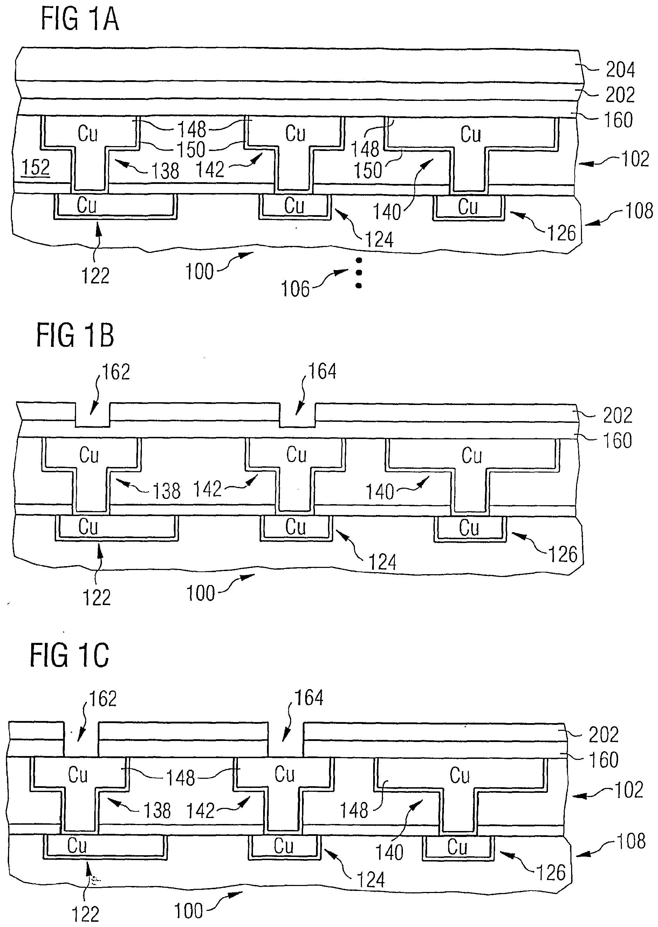

Zur Herstellung der Schaltungsanordnung 100 werden die folgenden Verfahrensschritte ausgeführt:
Herstellung der unteren Metallisierungslagen 106, 108 und 102 aus Kupfer, siehe Figur 1A:
   - Die unteren Metallisierungslagen 106, 108 und 102 werden durch Kupferabscheidung oder durch Abscheidung einer Kupferlegierung in einem Material mit einer kleinen Dielektrizitätskonstanten k hergestellt, wobei beispielsweise die Damascene-Technik oder die duale Damascene-Technik verwendet wird. Außerdem wird unterhalb der Bondverbindung 110 u.a. zur mechanischen Stabilisierung die Leitbahn 122 bzw. eine Vielzahl von Kontaktlöchern angeordnet, d.h. ein sogenannter "sea of vias".
   - Das Siliziumdioxid 152 bzw. ein anderes Material, z.B. FSG (Fluoride Silicate Glass), wird aufgebracht und mit Hilfe eines Lithografieverfahrens strukturiert. Anschließend werden die Liner-/Barriereschicht 150 und das Kupfer 148 abgeschieden.
   - Die Liner-/Barriereschicht 150 und das Kupfer 148 werden dann etwa bis auf die Höhe des Siliziumdioxids 152 mit Hilfe eines chemisch-mechanischen Polierverfahrens (CMP - Chemical Mechanical Polishing) abgetragen. Anschließend wird die Oberfläche gesäubert, beispielsweise mit Hilfe einer bürstenunterstützten Reinigung (Brush Clean).

Danach wird die Zwischenlage 160 hergestellt, die als Dielektrikum und als Barriereschicht dient. Bspw. gibt es die folgenden Varianten zur Herstellung der Zwischenlage 160:
a) Es werden ca. 100 nm Siliziumnitrid als dielektrische Diffusionsbarriere und als Intermetall-Dielektrikum zur obersten Metallisierungslage 104 abgeschieden, beispielsweise mit Hilfe eines CVD-Verfahrens (Chemical Vapor Dispostition), mit Hilfe eines PECVD-Verfahrens (Plasma Enhanced CVD) oder auch mit Hilfe von ALD-Verfahren (Atomic Layer Deposition).
b) Es wird zunächst eine Schicht kleiner 20 nm Siliziumnitrid mit einem HDP-Verfahren (High Density Plasma) abgeschieden. Auf Grund des zusätzlichen Ionenbeschusses bei diesem Verfahren wird diese Siliziumnitridschicht verfestigt und bietet somit eine optimale Zuverlässigkeit gegen Elektromigration des Kupfers 148. Danach wird ein sogenannter Pre-clean durchgeführt. Anschließend werden etwa 80 nm Siliziumnitrid mit Hilfe eines PECVD-Verfahrens abgeschieden, wobei die Abscheidung vorzugsweise mehrmals unterbrochen wird, um einen Mehrschichtstapel zu erzeugen, der eine optimale dielektrische Durchbruchsfestigkeit bietet.
c) Zunächst wird auf der gesäuberte Metallisierungslage 102 eine Siliziumnitridschicht mit einer Dicke kleiner 20 nm unter Verwendung eines HDP-Verfahrens abgeschieden. Diese Schicht bietet optimale Zuverlässigkeit gegen Elektromigration. Danach werden etwa 80 nm eines Dielektrikums mit einer hohen Dielektrizitätskonstante k abgeschieden, um eine maximale flächenbezogene Kapazität zu erzielen. Geeignete Materialien sind unter anderem Aluminiumoxid Al₂O₃ oder Tantalpentoxid Ta₂O₅, die vorzugsweise mit einem ALD-Verfahren (Atomic Layer Deposition) abgeschieden werden oder im Fall von Tantalpentoxid durch Anodisieren, d.h. durch Aufbringen von Tantal mit anschließender Oxidation.
d) Es werden ca. 80 nm oder ca. 100 nm Aluminiumoxid (Al₂O₃) als Intermetall-Dielektrikum zur obersten Metallisierungslage 104 abgeschieden.
e) Es wird ein Schichtstapel aus ca. 15 nm Al₂O₃, ca. 30 nm Ta₂O₅ und ca. 15 nm Al₂O₃ abgeschieden.
f) Oder es werden andere Materialien mit großer Dielektrizitätskonstante k verwendet, z.B. Aluminiumnitrid AlN, Hafniumdioxid HfO₂, Tantalpentoxid Ta₂O₅, Zirkoniumdioxid ZrO₂, BST (Barium-Strontium-Titanat), PZT (Blei-Zirkonium-Titanat). Bei Weiterbildungen wird unter diesen Materialien eine dünne Schicht von bspw. 20 nm Siliziumnitrid SiN oder Siliziumkarbid SiC als Kupferbarriere angeordnet.

Kontaktlochherstellung (Via), siehe weiter Figur 1A:
- Auf die Zwischenlage 160 wird eine Oxidschicht 202 als Hartmaskenschicht aufgebracht, bspw. mit einer Dicke von 100 nm (Nanometer) und unter Verwendung eines PECVD-Verfahrens. Danach wird eine Fotolackschicht 204 aufgebracht, gemäß den Strukturen für die Kontaktlöcher 162 und 164 belichtet und entwickelt.
- Die Kontaktlöcher 162 und 164 werden in einer ersten Ätzstufe in die Oxidschicht 202 geätzt, wobei auf bzw. in der Zwischenschicht 160 zeitgesteuert oder mit Endpunkterfassung gestoppt wird, siehe Figur 1B.
- Die Reste der Fotolackschicht 204 werden bspw. nasschemisch entfernt.

Wie in Figur 1C dargestellt, wird bei noch nicht vollständig strukturierter Zwischenschicht 160 jedoch bei bereits entfernter Fotolackschicht 204 anschließend die zweite Stufe zur Ätzung der Zwischenschicht 160 durchgeführt, um das Kupfer 148 im Bereich der Kontaktlöcher 162 und 164 freizulegen.

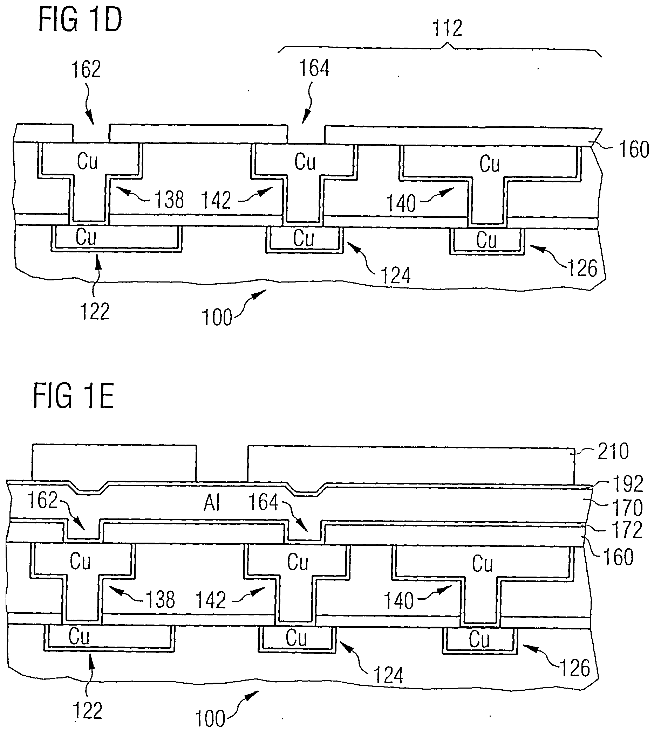

Wie in Figur 1D gezeigt, wird danach die als Hartmaske genutzte Oxidschicht 202 entfernt, wobei eine nasschemische Ätzung verwendet wird, um die Zwischenlage 160 insbesondere im Bereich des Kondensators 112 nicht bzw. nur in einem vernachlässigbaren Maße zu schädigen. Damit das Kupfer 148 im Bereich der Kontaktlöcher 162 und 164 nicht oxidiert, wird unter einer Inertgasatmosphäre geätzt, z.B. in einer Stickstoff oder Argonatmosphäre. Als Ätzbad ist bspw. Flusssäure HF geeignet. Die verwendete Ätzanlage ist handelsüblich.

Herstellung der Metallisierungslage 104, siehe Figur 1E:
- Die Barriereschicht 172 wird abgeschieden, wobei eine Sputter-Vorreinigung oder eine reaktive Vorreinigung, z.B. auf H₂-Basis, ausgeführt wird. Geeignete Materialien für die metallische Diffusionsbarriere sind Ta, TaN, Ti, TiN, W, WN, usw. Geeignete Abscheideverfahren sind das PVD-Verfahren (Physical Vapor Deposition) oder das CVD-Verfahren.
- Das Aluminium 170 oder eine Aluminiumlegierung, z.B. AlCu mit weniger als 5 Masseprozent Kupfer, wird mit Hilfe eines PVD-Verfahrens oder mit Hilfe eines CVD-Verfahrens abgeschieden, insbesondere auch in den Kontaktlöchern 162 und 164. Auch andere Schichtstapel für die Metallisierung der letzten Metallisierungslage 104 werden verwendet.

- Die Liner-/Antireflexionsschicht 192 wird abgeschieden, beispielsweise eine Titannitridschicht, die mit Hilfe eines PVD-Verfahrens abgeschieden wird.
- Es wird unter Aufbringung einer Fotolackschicht 210 ein Lithografieverfahren zur Strukturierung des Aluminiums 170 sowie der Schichten 172 und 192 durchgeführt, wobei die Lage der Anschlussplatte 180 und der oberen Elektrode 182 festgelegt werden.
- Die Liner-/Antireflexionsschicht 192, das Aluminium 170 und die Barriereschicht 172 werden geätzt, wobei an der oberen Fläche der Zwischenlage 160 gestoppt wird. Diese Ätzung ist ausreichend selektiv zur Zwischenlage 160, so dass die Restdicke der Zwischenlage 160 ausreichenden Schutz gegen eine Kupferdiffusion bietet.
- Der Fotolack wird entfernt und es wird ein Säuberungsschritt durchgeführt.

Abschließende Passivierung, siehe Figur 1F:
- Es wird das Siliziumdioxid 190 bzw. ein anderes geeignetes Material, z.B. FSG, abgeschieden. Anschließend wird die Nitridschicht 194 abgeschieden.
- Es wird unter Aufbringung einer weiteren nicht dargestellten Fotolackschicht ein Lithografieverfahren zum Festlegen der Lage der Aussparung 196 ausgeführt, d.h. der zur Anschlussplatte 180 führenden Öffnung.
- Die Aussparung 196 wird geätzt.
- Die Restbereiche der weiteren Fotolackschicht werden entfernt und es wird ein Säuberungsschritt ausgeführt.

Optional kann die Öffnung der Aussparung 196 auch mit einem fotosensitiven Polyimid als Maske erfolgen. Das an Hand der Figuren 1A bis 1F erläuterte Verfahren lässt sich auch dann ausführen, wenn in der Metallisierungslage 102 oder auch in allen unteren Metalagen an Stelle des Kupfers eine Kupferlegierung, Aluminium oder einer Aluminiumlegierung verwendet wird. Dabei bleiben insbesondere die Varianten zur Herstellung der Zwischenlage 160 und die Verfahrensschritte zum Herstellen der darüber liegenden Struktur unverändert.

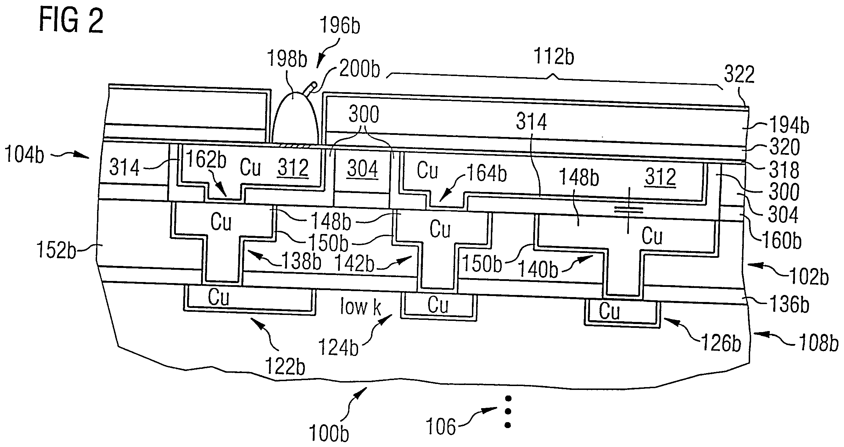

An Stelle des Aluminiums in der Metallisierungslage 104 lässt sich auch Kupfer oder eine Kupferlegierung verwenden. Will man die sich beim Ätzen des Kupfers ergebenden Nachteile vermeiden, so wird das Kupfer mit einer Dualen-Damascene-Technik strukturiert, siehe Figur 2.

Figur 2 zeigt eine Schaltungsanordnung 100b mit einer vorletzten Metallisierungslage 102b und einer letzten Metallisierungslage 104b, die beide Kupfer oder eine Kupferlegierung enthalten. Bei der Schaltungsanordnung 100b wurden in der obersten Metallisierungslage 104b zuerst Gräben für Verbindungsabschnitte der Metallisierungslage 104b hergestellt. Erst danach wurden eine Zwischenlage 300 abgeschieden und Kontaktlöcher 162b und 164b hergestellt. In der Figur 2 werden Elemente mit der gleichen Struktur und Funktion wie Elemente, die an Hand der Figuren 1A bis 1C erläutert worden sind, durch gleiche Bezugszeichen bezeichnet, wobei den Bezugszeichen jedoch zur Unterscheidung der Kleinbuchstabe b nachgestellt ist. Diese Elemente werden nicht noch einmal erläutert, weil die obenstehenden Erläuterungen gelten.

Zwischen der Figur 2 und den Figuren 1A bis 1F ergeben sich Abweichungen, die beim Erläutern der Verfahrensschritte zum Herstellen der Schaltungsanordnung 100b deutlich werden:
Herstellen der unteren Metallisierungslagen 106b, 108b und 102b:
   - es wird auf die Ausführungen zur Figur 2 verwiesen.

Herstellung einer Barriereschicht 160b:
- auf der eingeebneten Metallisierungslage 102b wird eine Barriereschicht 160b mit einer Dicke größer als 20 nm, z.B. von 50 nm, beispielsweise mit Hilfe eines PECVD-Verfahrens oder mit Hilfe eines HDP-Verfahrens abgeschieden. Die Barriereschicht 160b besteht beispielsweise aus Siliziumnitrid oder einem Material mit einer kleinen E-lektrizitätskonstante k (BLOK), z.B. Siliziumkarbid.

Herstellung der Metallisierungslage 104b, Grabenherstellung:
- es wird eine Oxidschicht, z.B. eine Siliziumdioxidschicht 304, auf der Barriereschicht 160b abgeschieden. Alternativ lässt sich auch ein anderes Material verwenden, z.B. FSG.
- Es wird ein Lithografieverfahren zum Festlegen der Lage für die Gräben ausgeführt, in denen später Kupfer 312 eingebracht werden soll.
- Die Gräben werden geätzt, wobei auf der Barriereschicht 160b gestoppt wird.
- Der Fotolack wird entfernt, um eine Oxidation des Kupfers zu verhindern.
- Im Bereich der Gräben wird die Barriereschicht 160b durchätzt. Um eine vollständige Entfernung der Gebiete der Barriereschicht 160b oberhalb des Kupfers 148b zu gewährleisten, muss etwas überätzt werden. Dies führt zu tieferen Gräben in Bereichen, in denen kein Kupfer 148b, sondern Siliziumdioxid 152b liegt.

Varianten zur Herstellung der Zwischenlage 300:
d, e, f) vgl. Variante d, e bzw. f zur Herstellung der Zwischenlage 160.
g) Es wird eine Siliziumnitridschicht mit einer Dicke größer als 50 nm als dielektrische Diffusionsbarriere und Intermetall-Dielektrikum abgeschieden. Die Dicke des Dielektrikums ist durch die Ätzselektivität zwischen Oxidschicht/FSG und Siliziumnitrid begrenzt. Nach der Ätzung des Grabens für die obere Elektrode 182a muss im Bereich des Kondensators 112a noch ein elektrisch zuverlässiges Dielektrikum übrig bleiben.
h) Es wird zunächst eine Siliziumnitridschicht mit einer Dicke kleiner 20 nm abgeschieden. Dabei wird ein HDP-Verfahren eingesetzt, um eine optimale Zuverlässigkeit gegenüber Elektromigration zu erreichen. Anschließend wird eine Siliziumnitridschicht größer 30 nm mit einem PECVD-Verfahren abgeschieden, vorzugsweise als Mehrfachschichtstapel für eine optimale dielektrische Durchbruchsfestigkeit.
i) Zunächst wird eine Siliziumnitridschicht mit einer Dicke kleiner 20 nm unter Verwendung eines HDP-Verfahrens abgeschieden. Anschließend wird eine Schicht mit einer Dicke größer 30 nm abgeschieden, die aus einem Dielektrikum mit einer hohen Dielektrizitätskonstante k besteht, z.B. Al₂O₃ oder Ta₂O₅. Diese Schicht führt zu einer maximalen flächenbezogenen Kapazität des linearen Kondensators 112b bzw. von Blockkondensatoren in der Schaltungsanordnung 100b. Auch in diesem Fall sollte die Gesamtdicke der Zwischenlage 300 größer als 50 nm sein. Die Dicke der Zwischenlage 300 ist durch die Ätzselektivität zwischen Oxidschicht/FSG und der Schicht mit der hohen Dielektrizitätskonstante k nach unten hin begrenzt.

Anschließend wird eine als Hartmaskenschicht dienende nicht dargestellten Oxidschicht aufgebracht, z.B. eine Siliziumdioxidschicht mit einer Dicke von 100 nm.

Herstellung von Kontaktlöchern (Vias):
- mit Hilfe einer auf die Oxidschicht aufgebrachten ebenfalls nicht dargestellten Fotolackschicht und eines Lithografieverfahrens wird die Lage der Kontaktlöcher 162b und 164b sowie weiterer nicht dargestellter Kontaktlöcher festgelegt.
- Die Kontaktlöcher 162b und 164b werden in die als Hartmaskenschicht dienende Oxidschicht geätzt.
- Der Fotolack wird entfernt.
- mit Hilfe der als Hartmaskenschicht dienende Oxidschicht werden die Kontaktlöcher 162b und 164b in die Zwischenlage 160b hinein bis zum Kupfer 148b erweitert.
- Die Oxidschicht wird mit einem nasschemischen Verfahren entfernt, dass selektiv zur Zwischenlage 160b ist, so dass die Zwischenlage 160b, insbesondere im Bereich des Kondensators 112b, nicht geschädigt wird.

Weitere Herstellung der Metallisierungslage 104a:
- Eine Barriereschicht 314 wird abgeschieden, wobei eine Sputter-Vorreinigung oder eine reaktive Vorreinigung (z.B. auf der Basis von H₂) ausgeführt werden sollte. Die Abscheidung der Barriereschicht 314 wird beispielsweise mit Hilfe eines PVD-Verfahrens oder mit Hilfe eines CVD-Verfahrens durchgeführt. Es lassen sich die gleichen Materialien verwenden, wie für die Barriereschicht 172.
- Es wird anschließend eine Kupferschicht mit Wachstumskeimen abgeschieden, z.B. mittels PVD-Verfahren oder mittels CVD-Verfahren, oder mittels eines stromlosen Verfahrens aus einer Lösung.
- Das Kupfer 312 wird mit Hilfe eines Dualen-Damascene-Füllverfahrens eingebracht, beispielsweise mit Hilfe eines ECD-Verfahrens (Electro Chemical Deposition).
- Das Kupfer 312 und die Barriereschicht 314 werden mit Hilfe eines CMP-Verfahrens außerhalb der Gräben abgetragen.
- Eine Barriereschicht 318 wird aufgebracht. Die Barriereschicht 318 hat eine Dicke von etwa 20 nm bis etwa 30 nm. Beispielsweise wird Siliziumnitrid mit Hilfe eines PECVD-Verfahrens oder mit Hilfe eines HDP-Verfahrens aufgebracht. Es lassen sich jedoch auch andere Materialien verwenden, z.B. ein Barrierenmaterial mit einer kleinen Dielektrizitätskonstante k (BLOK - Barrier low k).

Herstellung der Passivierung:
- Anschließend wird die Passivierung hergestellt, beispielsweise durch Aufbringen der Siliziumdioxidschicht 320 und der Siliziumnitridschicht 194b.
- Es wird ein Lithografieverfahren zum Festlegen der Lage der Aussparung 196b durchgeführt.
- Die Aussparung 196b wird geätzt, wobei auf der Barrierenschicht 318 gestoppt wird.
- Der Fotolack wird entfernt.
- Die Barriereschicht 318 wird im Bereich der Aussparung 196b durchgeätzt.
- Es wird eine extrem dünne aber dichte dielektrische Schicht 322 abgeschieden, die beispielsweise eine Dicke kleiner 5 nm hat. Zum Abscheiden wird beispielsweise ein ALCVD-Verfahren (Atomic Layer CVD) verwendet. Als Material ist Siliziumnitrid geeignet. Durch die dielektrische Schicht 322 wird die Kupferanschlussplatte 162b vor Korrosion und Oxidation geschützt. Die dielektrische Schicht 322 muss jedoch so dünn sein, dass trotzdem auf der Kupferanschlussplatte 182b gebondet werden kann.

Bei anderen nicht erfindungsgemäßen Ausführungsbeispielen wird an Stelle der als Hartmaske dienenden Oxidschicht 202 eine als Hartmaske dienende Titanschicht oder eine Titannitridschicht verwendet, die beispielsweise eine Dicke von 50 nm oder 100 nm haben. Alternativ lässt sich auch ein anderes geeignetes leitfähiges Material als Hartmaske verwenden. Die Hartmaskenschicht verbleibt zumindest mit einer vorgegebenen Schichtdicke und in mindestens einem Bereich in der integrierten Schaltungsanordnung 100 bzw. 100b, insbesondere im Bereich des Kondensators 112 bzw. 112b. Beispielsweise beträgt die verbleibende Schichtdicke 40 nm.

Bei dem an Hand der Figur 1F erläuterten Verfahren wird die nicht erfindungsgemäße elektrisch leitfähige Hartmaskenschicht beim Strukturieren des Aluminiums 170 mitstrukturiert. Die Liner-/Barriereschicht 172 wird beispielsweise mit einer Dicke von 50 nm auf die verbleibende elektrisch leitfähige Hartmaskenschicht aufgebracht. Bei einem anderen Ausführungsbeispiel wird keine zusätzliche Liner-Barriereschicht 172 mehr aufgebracht.

Bei dem an Hand der Figur 2 erläuterten Verfahren verbleibt die mit Öffnungen für die Kontaktlöcher 162b und 164b versehene nicht erfindungsgemäße elektrisch leitfähige Hartmaskenschicht in den Gräben für das Kupfer 312. Auf die Hartmaskenschicht wird die Liner-/Barriereschicht 314 aufgebracht, beispielsweise in einer Dicke von nur 50 nm. Bei einer Ausgestaltung wird keine zusätzliche Liner-/Barriereschicht 314 zu der Hartmaskenschicht aufgebracht.

Die außerhalb der Gräben für das Kupfer 312 liegenden Bereiche der nicht erfindungsgemäßen elektrisch leitfähigen Hartmaskenschicht werden beim CMP-Verfahren gemeinsam mit den außerhalb der Gräben liegenden Bereichen der Zwischenlage 300 entfernt.

Bei anderen alternativen nicht erfindungsgemäßen Ausführungsbeispielen wird eine Hartmaskenschicht verwendet, die eine untere elektrisch leitfähige Schicht und eine darüber liegende elektrisch isolierende Schicht enthält. Beispielsweise enthält die Hartmaskenschicht eine Titanschicht bzw. eine Titannitridschicht mit einer Dicke von beispielsweise 50 nm und eine darüber liegende Oxidschicht mit einer Dicke von beispielsweise 100 nm. Bei den an Hand der Figuren 1A bis 1F und der Figur 2 erläuterten Verfahren wird an Stelle des Schrittes zum Entfernen der Hartmaske nur die elektrisch isolierende Schicht der Hartmaske entfernt. Die nicht erfindungsgemäße elektrisch leitfähige Schicht der Hartmaske wird dagegen nur bereichsweise bei der späteren Strukturierung des Aluminiums 170 bzw. bei dem CMP-Verfahren zum Planarisieren des Kupfers 312 entfernt. Die verbleibenden Bereiche der Hartmaskenschicht haben die Dicke der ursprünglichen Hartmaskenschicht oder sind gedünnt im Vergleich zur ursprünglichen Dicke der Hartmaskenschicht. Auch in diesen Fällen können die Liner/Barriereschichten 172 bzw. 314 vorgesehen sein oder ganz entfallen.

Selbstverständlich lassen sich die Kondensatoren 112 und 112b auch von oben her mit Hilfe einer Bondverbindung oder einer Verdrahtung in der oberen Metallisierungslage anschließen.

Bei anderen Ausführungsbeispielen enthält die obere Metallisierungslage 104, 104b auch Leitbahnen, zur Verdrahtung verschiedener Bauelemente.

Die an Hand der Figuren 1A bis 1F bzw. an Hand der Figur 2 erläuterten Verfahren und weiteren Ausführungsbeispiele lassen sich auch dann einsetzen, wenn die Metallisierungslagen 102 und 104 bzw. 102b und 104b nicht so nahe benachbart sind, d.h. beispielsweise bei Abständen zwischen den Leitbahnen in den Metallisierungslagen von mehreren 100 nm.

## Patentansprüche

1. Verfahren zum Herstellen einer integrierten Schaltungsanordnung (100),
mit den in der angegebene Reihenfolge ausgeführten Schritten:
Aufbringen einer dielektrischen Schicht (160, 300) auf eine Metallisierungslage (102), die eine Vielzahl von Leitbahnen und mindestens eine erste Elektrode (140) enthält, wobei die dielektrische Schicht (160, 300) eine Dicke kleiner als 150 nm hat,
Aufbringen mindestens einer Hartmaskenschicht (202) auf die dielektrische Schicht (160, 300),
Aufbringen einer Resistschicht (204) auf die Hartmaskenschicht (202),
Strukturieren der Hartmaskenschicht (202) mit Hilfe der Resistschicht (204), wobei die dielektrische Schicht (160, 300) nicht vollständig strukturiert wird, indem ein Kontaktloch oder ein Via (162, 164) nicht vollständig geöffnet wird,
Entfernen von Resten der Resistschicht (204),
nach dem Entfernen der Reste der Resistschicht (204) vollständiges Strukturieren der dielektrischen Schicht (160, 300) mit Hilfe der Hartmaskenschicht (202), wobei das Kontaktloch oder das Via (162, 164) vollständig geöffnet und ein darunter liegender Bereich mindestens einer zweiten Elektrode (138) der Metallisierungslage (102) freigelegt wird,
wobei nach dem Strukturieren der dielektrischen Schicht (160, 300) eine weitere Metallisierungslage (104) erzeugt wird, die eine Vielzahl von Leitbahnen enthält,
wobei die dielektrische Schicht (160, 300) bei dem nicht vollständigen Strukturieren nicht durchätzt wird,
wobei beim Entfernen der Reste der Resistschicht (204) die Elektroden (138, 140) noch durch die dielektrische Schicht (160) geschützt sind,
und wobei die Reste der Resistschicht mit einem Verfahren entfernt werden, das sich vom Verfahren zur Strukturierung der dielektrischen Schicht (160, 300) unterscheidet,
**dadurch gekennzeichnet, dass** beide Metallisierungslagen (102, 104) außerhalb des Kontaktlochs oder Vias (162, 164) durch die dielektrische Schicht (160, 300) weniger als 100 nm voneinander beabstandet sind, und
dass eine an die dielektrische Schicht (160, 300) angrenzende Schicht der Hartmaskenschicht (202) eine elektrisch isolierende Schicht ist, die wieder entfernt wird.

2. Verfahren nach Anspruch 1, **dadurch gekenn- zeichnet,** dass die Hartmaskenschicht (202) nass-chemisch oder trockenchemisch entfernt wird,
und/oder dass die Hartmaskenschicht (202) unter Ausschluss von Sauerstoff geätzt wird,
und/oder dass die Hartmaskenschicht (202) in einer Inertgasatmosphäre geätzt wird,
und/oder dass die Hartmaskenschicht (202) vollständig entfernt wird.

3. Verfahren nach einem der vorhergehenden Ansprüche, **dadurch gekennzeichnet, dass** vor dem Aufbringen der dielektrischen Schicht (300) mindestens ein Graben erzeugt wird,
und dass die dielektrische Schicht (300) auch am Boden des Grabens aufgebracht wird.

4. Verfahren nach einem der vorhergehenden Ansprüche, **dadurch gekennzeichnet, dass** die Hartmaskenschicht (202) aus einer Oxidschicht besteht oder eine Oxidschicht enthält, insbesondere eine Siliziumdioxidschicht.

5. Verfahren nach einem der vorhergehenden Ansprüche, **dadurch gekennzeichnet, dass** die dielektrische Schicht (160) aus Siliziumnitrid besteht oder eine Siliziumnitridschicht enthält,
und/oder dass die dielektrische Schicht (160) aus einer Siliziumkarbidschicht besteht oder eine Siliziumkarbidschicht enthält,
und/oder dass die dielektrische Schicht (160) aus einer Aluminiumoxidschicht besteht oder eine Aluminiumoxidschicht enthält,
und/oder dass die dielektrische Schicht (160) mindestens eine Schicht aus einem Material mit einer Dielektrizitätskonstanten größer 3,9 enthält, insbesondere Aluminiumnitrid, Hafniumdioxid, Tantalpentoxid, Zirkoniumdioxid, Bariumstrontiumtitanat und/oder Bleizirkoniumtitanat,
und/oder dass die dielektrische Schicht einen Schichtstapel mit Schichten verschiedener Materialien enthält, insbesondere den genannten Materialien.

6. Verfahren nach einem der vorhergehenden Ansprüche, **dadurch gekennzeichnet, dass** die Elektrode der Metallisierungslage (102) aus einem Material besteht, das beim Entfernen der Resistschicht (204) ohne Verwendung der Hartmaskenschicht angegriffen werden würde, insbesondere aus Kupfer, aus einer Kupferlegierung, aus Silber oder einer Silberlegierung,
und/oder dass das angreifbare Material der Metallisierungslage (102) an die dielektrische Schicht (160) angrenzt.

7. Verfahren nach einem der vorhergehenden Ansprüche, **dadurch gekennzeichnet, dass** die weitere Metallisierungslage (104) mindestens eine Elektrode (170) aus Aluminium, aus einer Aluminiumlegierung, aus Kupfer oder aus einer Kupferlegierung enthält,
und/oder dass die weitere Metallisierungslage (104) mindestens eine Leitbahn zur Verdrahtung von verschiedenen Bauelementen der Schaltungsanordnung (100, 100b) enthält.

8. Verfahren nach einem der vorhergehenden Ansprüche, **dadurch gekennzeichnet , dass** die erste Elektrode Teil einer Kondensatoranordnung (112) ist, die einen Teil der dielektrischen Schicht (160) und eine Elektrode (182) in der weiteren Metallisierungslage (104) enthält.

## Claims

1. Method for production of an integrated circuit arrangement (100),
comprising the following steps, which are carried out in the stated sequence:
application of a dielectric layer (160, 300) to a metallization layer (102) which contains a large number of interconnects and at least one first electrode (140), with the dielectric layer (160, 300) having a thickness of less than 150 nm,
application of at least one hard mask layer (202) to the dielectric layer (160, 300),
application of a resist layer (204) to the hard mask layer (202),
structuring of the hard mask layer (202) with the aid of the resist layer (204), with the dielectric layer (160, 300) not being completely structured in that a contact hole or a via (162, 164) is not completely opened,
removal of the residues of the resist layer (204),
after the removal of the residues of the resist layer (204), complete structuring of the dielectric layer (160, 300) with the aid of the hard mask layer (202), with the contact hole or the via (162, 164) being completely opened and an area, which is located underneath it, of at least one second electrode (138) in the metallization layer (102) being exposed,
with a further metallization layer (104) which contains a large number of interconnects being produced after the structuring of the dielectric layer (160, 300) with the dielectric layer (160, 300) not being etched through during the non-complete structuring,
with the electrodes (138, 140) still being protected by the dielectric layer (160) during the removal of the residues of the resist layer (204),
and with the residues of the resist layer being removed using a method which is not the same as the method used for structuring of the dielectric layer (160, 300),
**characterized in that** both metallization layers (102, 104) are spaced apart from one another by less than 100 nm by the dielectric layer (160, 300) outside the contact hole or via (162, 164), and
**in that** a layer of the hard mask layer (202) which is adjacent to the dielectric layer (160, 300) is an electrically insulating layer which is removed once again.

2. Method according to Claim 1, **characterized in that** the hard mask layer (202) is removed wet-chemically or dry-chemically,
and/or **in that** the hard mask layer (202) is etched with oxygen being excluded,
and/or **in that** the hard mask layer (202) is etched in an inert gas atmosphere,
and/or **in that** the hard mask layer (202) is removed completely.

3. Method according to either of the preceding claims, **characterized in that** at least one trench is produced before the application of the dielectric layer (300),
and **in that** the dielectric layer (300) is also applied to the base of the trench.

4. Method according to one of the preceding claims, **characterized in that** the hard mask layer (202) is composed of an oxide layer or contains an oxide layer, in particular a silicon dioxide layer.

5. Method according to one of the preceding claims, **characterized in that** the dielectric layer (160) is composed of silicon nitride or contains a silicon nitride layer,
and/or **in that** the dielectric layer (160) is composed of a silicon carbide layer or contains a silicon carbide layer,
and/or **in that** the dielectric layer (160) is composed of an aluminum oxide layer or contains an aluminum oxide layer,
and/or **in that** the dielectric layer (160) contains at least one layer composed of a material having a dielectric constant of more than 3.9, in particular aluminum nitride, hafnium dioxide, tantalum pentoxide, zirconium dioxide, barium strontium titanate and/or lead zirconium titanate,
and/or **in that** the dielectric layer contains a layer stack with layers of different materials, in particular the said materials.

6. Method according to one of the preceding claims, **characterized in that** the electrode in the metallization layer (102) is composed of a material which would be attacked during the removal of the resist layer (204) without the use of the hard mask layer, and in particular is composed of copper, of a copper alloy, of silver or of a silver alloy,
and/or **in that** the material of the metallization layer (102) which can be attacked is adjacent to the dielectric layer (160).

7. Method according to one of the preceding claims, **characterized in that** the further metallization layer (104) contains at least one electrode (170) composed of aluminum, of an aluminum alloy, of copper or of a copper alloy,
and/or **in that** the further metallization layer (104) contains at least one interconnect for wiring of different components in the circuit arrangement (100, 100b).

8. Method according to one of the preceding claims, **characterized in that** the first electrode is part of a capacitor arrangement (112), which contains a part of the dielectric layer (160) and an electrode (182) in the further metallization layer (104).

## Revendications

1. Procédé de production d'un circuit (100) intégré,
ayant les stades effectués dans l'ordre indiqué:
dépôt d'une couche (160, 300) diélectrique sur une strate (102) de métallisation, qui comporte une pluralité de pistes conductrices et au moins une première électrode (104), la couche (160, 300) diélectrique ayant une épaisseur plus petite que 150 nm,
dépôt d'au moins d'une couche (202) de masque dur sur la couche (160, 300) diélectrique,
dépôt d'une couche (204) de résist sur la couche (202) de masque dur,
structuration de la couche (202) de masque dur à l'aide de la couche (204) de résist, la couche (160, 300) diélectrique n'étant pas structurée complètement, en ouvrant, non complètement, un trou de contact ou une traversée (162, 164),
élimination de restes de la couche (204) de résist,
après l'élimination des restes de la couche (204) de résist,
structuration compète de la couche (160, 300) diélectrique à l'aide de la couche (202) de masque dur, le trou de contact ou
une traversée (162, 164) étant ouvert complètement, et une région sous-jacente d'au moins une deuxième électrode (138) de la strate (102) de métallisation étant mise à nu,
dans lequel après la structuration de la couche (160, 300) diélectrique, on produit une autre strate (104) de métallisation, qui comporte une pluralité de pistes conductrices,
dans lequel on n'attaque pas la couche (160, 300) diélectrique lors de la structuration incomplète,
dans lequel, lors de l'élimination des restes de la couche (204) de résist, les électrodes (138, 140) sont encore protégées par la couche (160) diélectrique,
et dans lequel on élimine les restes de la couche de résist par un procédé qui se distingue du procédé de structuration de la couche (160, 300) diélectrique,
**caractérisé en ce que** les deux strates (102, 104) de métallisation sont, à l'extérieur du trou de contact ou de la traversée (162, 164) dans la couche (160, 300) diélectrique, à une distance l'une de l'autre de moins de 100 nm, et
**en ce qu'**une couche, voisine de la couche (160, 300) diélectrique, de la couche (202) de masque dur, est une couche isolante électriquement, qu'on réélimine.

2. Procédé suivant la revendication 1, **caractérisé en ce qu'**on élimine la couche (202) de masque dur par voie chimique humide ou par voie chimique sèche,
et/ou **en ce que** l'on attaque la couche (202) de masque dur à l'abri de l'oxygène,
et/ou **en ce qu'**on attaque la couche (202) de masque dur dans une atmosphère de gaz inerte,
et/ou **en ce que** on élimine complètement la couche (202) de masque dur.

3. Procédé suivant l'une des revendications précédentes, **caractérisé en ce qu'**avant le dépôt de la couche (300) diélectrique, on produit au moins un sillon,
et **en ce que** l'on dépose la couche (300) diélectrique au fond du sillon.

4. Procédé suivant l'une des revendications précédentes, **caractérisé en ce que** la couche (202) de masque dur est constituée d'une couche d'oxyde ou contient une couche d'oxyde, notamment une couche de dioxyde de silicium.

5. Procédé suivant l'une des revendications précédentes, **caractérisé en ce que** la couche (160) diélectrique est en nitrure de silicium ou contient une couche de nitrure de silicium,
et/ou **en ce que** la couche (160) diélectrique est en une couche de carbure de silicium ou contient une couche de carbure de silicium,
et/ou **en ce que** la couche (160) diélectrique est constituée d'une couche en oxyde d'aluminium ou contient une couche d'oxyde d'aluminium,
et/ou **en ce que** la couche (160) diélectrique contient au moins une couche en une matière ayant une constante diélectrique plus grande que 3,9, notamment en nitrure d'aluminium, dioxyde d'hafnium, pentoxyde de tantale, dioxyde de zirconium, titanate de barium et de strontium et/ou titanate de plomb et de zirconium,
et/ou **en ce que** la couche (160) diélectrique contient un empilement de couches ayant des couches en matières différentes, notamment en les matières mentionnées.

6. Procédé suivant l'une des revendications précédentes, **caractérisé en ce que** l'électrode de la strate (102) de métallisation est en une matière qui, si la couche (204) de résist avait été éliminée, aurait été attaquée sans l'utilisation de la couche de masque dur en étant notamment en cuivre, en un alliage de cuivre, en argent ou en un alliage d'argent,
et/ou **en ce que** la matière attaquable de la strate (102) de métallisation est voisine de la couche (160) diélectrique.

7. Procédé suivant l'une des revendications précédentes, **caractérisé en ce que** l'autre strate (104) de métallisation comporte au moins une électrode (170) en aluminium, en un alliage d'aluminium, en cuivre ou en un alliage de cuivre, et/ou **en ce que** l'autre strate (104) de métallisation contient au moins une piste conductrice de câblage de divers composants du circuit (100, 100b).

8. Procédé suivant l'une des revendications précédentes, **caractérisé en ce que** la première électrode fait partie d'un agencement (112) de condensateur, qui comporte une partie de la couche (160) diélectrique et une électrode (182) dans l'autre strate (104) de métallisation.
